# EUROPÄISCHE PATENTSCHRIFT

(11) **EP 3 622 704 B1**
(45) Veröffentlichungstag und Bekanntmachung des Hinweises auf die Patenterteilung: **16.06.2021**
(21) Anmeldenummer: 18726360.3
(22) Anmeldetag: 09.05.2018
(51) Int. Cl.: H04N 5/372, H01L 27/148

(54) **TDI-ZEILENDETEKTOR**
TDI LINE DETECTOR
DÉTECTEUR DE LIGNES TDI

(30) Priorität: 12.05.2017 DE 102017208041
(43) Veröffentlichungstag der Anmeldung: 18.03.2020
(73) Patentinhaber: Deutsches Zentrum für Luft- und Raumfahrt e.V., 51147 Köln (DE)
(72) Erfinder: ECKARDT, Andreas, 12524 Berlin (DE)
(74) Vertreter: Zucker, Volker
(86) Internationale Anmeldenummer: PCT/EP2018/062095
(87) Internationale Veröffentlichungsnummer: WO 2018/206694

(56) Entgegenhaltungen:
- DE-B3-102008 024 417
- JP-A- 2011 146 924
- US-A- 5 917 620
- US-A1- 2003 193 589
- US-A1- 2012 127 331

## Beschreibung

Die Erfindung betrifft einen TDI-Zeilendetektor.

Insbesondere auf dem Gebiet der Erdbeobachtung sind verschiedene Verfahren und Sensoren bekannt, die mit Hilfe verschiedener Sensoren (Zeilen oder Matrizen) aus dem Orbit die Erde abtasten. Mit Hilfe verschiedener Technologien wird versucht, die Auflösung des Instrumentes sowohl spektral als auch geometrisch zu maximieren. Beispiele für derartige Technologien sind Sensorarchitekturen mit TDI-Zeilendetektoren oder bewegungskompensierte Matrix- und/oder Zeilendetektoren.

Aus der DE 10 2008 024 417 B3 ist ein TDI-Zeilendetektor bekannt, umfassend n TDI-Zeilen, wobei jede TDI-Zeile m Pixel aufweist. Dabei ist mindestens einer äußeren Zeile eine Ausleseregister-Einheit zugeordnet, wobei jedem Pixel der ersten und/oder n-ten Zeile ein eigenes Register zugeordnet ist. Dabei ist zwischen zwei Pixeln jeder Zeile eine Maskierung vorgesehen, wobei die Maskierung eine Breite von einem Pixel oder einem ganzzahligen Vielfachen eines Pixels aufweist, wobei die Register der Pixel entsprechend der Breite der Maskierungen verbreitert sind. Weiter wird eine Detektoranordnung offenbart, die mindestens zwei TDI-Zeilendetektoren aufweist, wobei die TDI-Zeilendetektoren in Querrichtung um eine Pixelbreite jeweils versetzt zueinander angeordnet sind und in Längsrichtung jeweils um ein ganzzahliges Vielfaches einer Pixellänge zueinander versetzt angeordnet sind. Dabei sind die TDI-Zeilendetektoren vorzugsweise miteinander synchronisiert, wobei die Detektoranordnung auch monolithisch ausgebildet sein kann.

Aus der US 5 917 620 A sowie der US 2003/193589 A1 ist jeweils ein TDI-Zeilendetektor bekannt, umfassend n TDI-Zeilen, wobei jede TDI-Zeile m Pixel aufweist. Dabei ist der TDI-Zeilendetektor in x-Submodule unterteilt, wobei die Anzahl der Zeilen eines Submoduls n/x ist, wobei der letzten Zeile eines jeden Submoduls eine eigene Ausleseelektronik zugeordnet ist. Dabei entspricht die Länge der Ausleseelektronik einem ganzzahligen Vielfachen der Länge eines Pixels, wobei x ≥ 2 ist. Weiter sind die zugehörigen Pixel verschiedener Submudule pixelgenau untereinander angeordnet.

Aus der JP 2011-146924 A ist ein TDI-Zeilendetektor bekannt, umfassend n TDI-Zeilen, wobei jede Zeile m Pixel aufweist. Dabei ist der letzten Zeile eine Ausleseelektronik zugeordnet. Dabei ist der TDI-Zeilendetektor in x Submodule unterteilt, wobei die Anzahl der Zeilen eines Submoduls n/x ist. Die Submodule sind alternierend um ein halbes Pixel seitlich versetzt angeordnet, wobei zwischen den Submodulen Ladungsverteilungseinheiten angeordnet sind, mittels derer wahlweise ein Ladungspaket zu einem linken oder rechten darunter angeordneten Pixel geschoben werden kann.

Aus US 2012/127331 A1 ist ein Konzept bekannt wobei durch Versatz von unterschiedlichen TDI-Zeilendetektoren um einen Bruchteil einer Pixelbreite eine höhere Auflösung erzielt werden kann. Ein Problem bei TDI-Zeilendetektoren mit vielen TDI-Stufen ist die Stabilität, um den Jitter zwischen den Pixeln während der Aufnahme auf unter 1/3-Pixel zu begrenzen. Werden beispielsweise 1.000 Zeilen mit einer Taktfrequenz mit 10 kHz getaktet, so muss der Zeilendetektor für 100 ms derart stabil gehalten werden, dass die Anforderungen an den Jitter noch eingehalten werden. Dies schränkt insbesondere den Wunsch nach einer Vergrößerung der Zeilenanzahl ein. Aber bereits bei der herkömmlichen Anzahl von Zellen erfordert dies einen erhöhten Aufwand, beispielsweise aufgrund von sogenannten Mikrovibrationen in einem Satelliten.

Der Erfindung liegt das technische Problem zugrunde, einen TDI-Zeilendetektor mit den Merkmalen des Anspruchs 1. Weitere vorteilhafte Ausgestaltungen der Erfindung ergeben sich aus den Unteransprüchen.

Der TDI-Zeilendetektor umfasst n TDI-Zeilen, wobei jede TDI-Zeile m Pixel aufweist. Dabei ist der TDI-Zeilendetektor in x Submodule unterteilt, wobei die Anzahl der Zeilen eines Submoduls n/x ist Weiter ist jeder letzten Zeile eines jeden Submoduls eine eigene Ausleseelektronik zugeordnet, wobei die Länge der Ausleseelektronik einem ganzzahligen Vielfachen der Länge eines Pixels entspricht, wobei x ≥ 2 ist. Dabei ist anzumerken, dass die n TDI-Zeilen synchron angesteuert werden und der TDI-Zeilendetektor vorzugsweise als monolithischer Chip, weiter vorzugsweise in CMOS-Technik ausgebildet ist.

Die dann ausgelesenen Daten werden über ein Bussystem an eine Auswerteeinheit übertagen, wo diese mittels bekannter Verfahren miteinander korreliert werden. Ein mögliches Verfahren ist beispielsweise das Center of Gravity-Verfahren.

Dabei wird zusätzlich jedes zweite Submodul oder alternierend Gruppen von Submodulen um ein halbes Pixel seitlich versetzt angeordnet, was es erlaubt, die geometrische Auflösung zu erhöhen. Damit wird zusätzlich das Stabilitätsproblem um den Faktor x reduziert Zusätzlich sind die Pixel rechteckförmig, wobei die Pixel doppelt so breit wie lang sind. Somit ergeben sich in der Nachverarbeitung wieder quadratische Pixel.

In einer weiteren Ausführungsform ist 10 ≤ x ≤ 100. Dies stellt einen sehr guten Kompromiss zwischen Entschärfung des Stabilitätsproblems und dem Mehraufwand für die Ausleseelektroniken sowie die Nachbearbeitung der Daten dar.

In einer weiteren Ausführungsform weisen mindestens einige der Submodule Filter für verschiedene Spektralbereiche auf, sodass ein Multispektral-Sensor realisiert werden kann. Dieser kann mit panchromatischen Submodulen kombiniert werden. Bei einer solchen Ausführungsform ist beispielsweise vorgesehen, dass, wenn drei unterschiedliche Spektralbereiche abgebildet werden, drei Submodule eine Gruppe bilden, d.h. die ersten drei Submodule sind in einer Linie und die nachfolgenden drei Submodule sind um ein halbes Pixel seitlich versetzt angeordnet. Bei zusätzlicher Einbindung eines panchromatischen Submoduls würde dann die Gruppe aus vier Submodulen bestehen.

In einer weiteren Ausführungsform sind die Pixelgrößen für alle Zeilen gleich. Insbesondere bei gemischten Ausführungsformen, wo panchromatische und spektrale Submodule gemischt werden, werden so Aliasing-Effekte vermieden. Die spektralen Pixel können dann in der Auswerteeinheit beispielsweise mittels einer Makropixelbildung zusammengefasst werden, um ein verbessertes Signal-Rausch-Verhältnis zu erzielen.

Ein bevorzugtes Anwendungsfeld des TDI-Sensors ist der Einsatz in einem Satelliten.

Die Erfindung wird nachfolgend anhand bevorzugter Ausführungsbeispiele näher erläutert. Die Figuren zeigen:
- Fig. 1: einen TDI-Zeilendetektor in einer ersten nicht anspruchsgemäßen Ausführungsform und
- Fig. 2: einen TDI-Zeilendetektor in einer zweiten anspruchsgemäßen Ausführungsform.

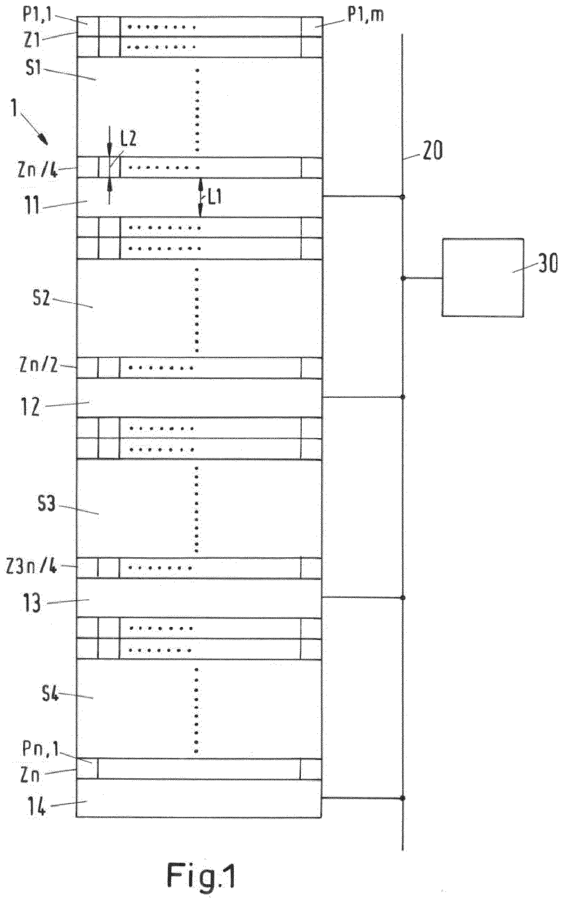

In der Fig. 1 ist schematisch ein TDI-Zeilendetektor 1 dargestellt, der insgesamt n Zeilen Z mit m Pixeln P aufweist. Dabei ist beispielsweise P1,1 das erste Pixel P der ersten Zeile, Z1 die erste Zeile und Zn die n-te Zeile. Dabei ist der TDI-Zeilendetektor 1 im dargestellten Beispiel in vier Submodule S1-S4 unterteilt, die jeweils n/4 Zeilen Z aufweisen. Die Größe aller Pixel P ist in allen Zeilen Z in allen Submodulen S1-S4 gleich. Der jeweils letzten Zeile Z eines Submoduls S1-S4 ist eine dem Submodul S1-S4 zugeordnete Ausleseelektronik 11-14 zugeordnet. Die Ausleseelektroniken 11-14 sind beispielsweise als Schieberegister ausgebildet und über mindestens ein Bussystem 20 mit einer Auswerteeinheit 30 verbunden. Dabei kann auch vorgesehen sein, dass jede Ausleseelektronik 11-14 über ein eigenes Bussystem mit der Auswerteeinheit 30 oder alternativ mit einem Massenspeicher verbunden ist.

Die Länge L1 der Ausleseelektroniken 11-14 ist dabei ein ganzzahliges Vielfaches der Länge L2 der Pixel P. Dabei sind die zugeordneten Pixel P pixelgenau untereinander angeordnet. Die Zeilen Z1-Zn sowie die Ausleseelektroniken 11-14 werden nun synchron getaktet. Durch diese Unterteilung in Submodule S1-S4 wird die Zeit, in der die Lage des TDI-Zeilendetektors 1 stabil sein muss (z.B. Abweichung in der räumlichen Lage kleiner als 1/3 Pixel), um den Faktor 4 reduziert. Dies kann nun beispielsweise auch dazu genutzt werden, die Anzahl n der Zeilen zu erhöhen, da die Stabilitätsbedingungen durch eine entsprechend hohe Anzahl von Submodulen leicht einzuhalten sind.

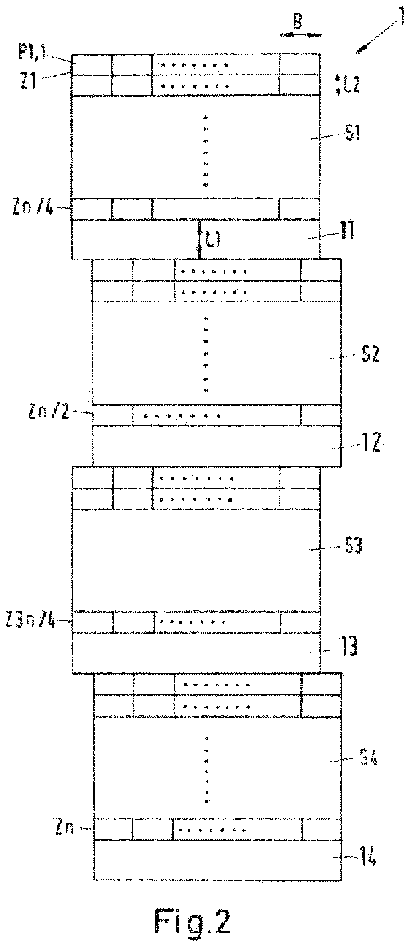

In der Fig. 2 ist eine alternative Ausführungsform eines TDI-Zeilendetektors 1 dargestellt, wobei gleiche Elemente gleiche Bezugszeichen aufweisen. Die Unterschiede zur Ausführungsform gemäß Fig. 1 sind die Form der Pixel P und die Anordnung der Submodule S1-S4. Die Pixel P weisen eine rechteckförmige Form auf, wobei die Breite B doppelt so groß ist wie die Länge L2 der Pixel P. Weiter sind die Submodule S1-S4 alternierend um ein halbes Pixel P seitlich versetzt. Im dargestellten Beispiel sind also das zweite Submodul S2 und das vierte Submodul S4 jeweils um eine halbe Pixelbreite B nach rechts versetzt angeordnet. Hierdurch wird erreicht, dass die effektive Pixelfläche vergrößert wird, was das Signal-Rausch-Verhältnis verbessert. Durch die gestaggerte Anordnung kann dann durch die Nachbearbeitung, bei der die Daten der verschiedenen Submodule S1-S4 korreliert werden, die reduzierte geometrische Auflösung aufgrund der vergrößerten Pixelflächen wieder kompensiert werden.

Dies ist insbesondere für multispektrale Aufnahmen von Interesse, da dort üblicherweise größere Pixelflächen zur Anwendung kommen.

## Patentansprüche

1. TDI-Zeilendetektor (1), umfassend n TDI-Zeilen (Z1-Zn), wobei jede TDI-Zeile (Z) m Pixel (P) aufweist, sowie mindestens eine Ausleseelektronik (11-14),
**dadurch gekennzeichnet, dass**
der TDI-Zeilendetektor (1) in x Submodule (S1-S4) unterteilt ist, wobei die Anzahl der Zeilen (Z) eines Submoduls (S1-S4) n/x ist, wobei der letzten Zeile eines jeden Submoduls (S1-S4) eine eigene Ausleseelektronik (11-14) zugeordnet ist, wobei die Länge (L1) der Ausleseelektronik (11-14) einem ganzzahligen Vielfachen der Länge (L2) eines Pixels (P) entspricht, wobei x ≥ 2 ist, wobei die Submodule (S1-S4) oder Gruppen von Submodulen (S1-S4) alternierend um ein halbes Pixel (P) seitlich versetzt angeordnet sind, wobei die Pixel (P) rechteckförmig sind, wobei die Pixel (P) doppelt so breit wie lang sind.

2. TDI-Zeilendetektor nach Anspruch 1, **dadurch gekennzeichnet, dass** 10 ≤ x ≤ 100 ist.

3. TDI-Zeilendetektor nach Anspruch 1 oder 2, **dadurch gekennzeichnet, dass** mindestens einige der Submodule (S1-S4) Filter für verschiedene Spektralbereiche aufweisen.

4. TDI-Zeilendetektor nach einem der vorangegangenen Ansprüche, **dadurch gekennzeichnet, dass** die Pixelgröße für alle Zeilen gleich ist.

## Claims

1. TDI line-scan detector (1), comprising n TDI lines (Zl-Zn), wherein each TDI line (Z) has m pixels (P), and at least one read electronic system (11-14),
**characterized in that**
the TDI line-scan detector (1) is divided into x submodules (S1-S4), wherein the number of lines (Z) of a submodule (S1-S4) is n/x, wherein the last line of each submodule (S1-S4) is assigned a dedicated read electronic system (11-14), wherein the length (L1) of the read electronic system (11-14) corresponds to an integer multiple of the length (L2) of a pixel (P), wherein x is ≥ 2, wherein the submodules (S1-S4) or groups of submodules (S1-S4) are arranged in alternation with a lateral offset of half a pixel (P), wherein the pixels (P) are rectangular, wherein the pixels (P) are twice as wide as they are long.

2. TDI line-scan detector according to Claim 1, **characterized in that** 10 ≤ x ≤ 100.

3. TDI line-scan detector according to Claim 1 or 2, **characterized in that** at least some of the submodules (S1-S4) have filters for different spectral ranges.

4. TDI line-scan detector according to one of the preceding claims, **characterized in that** the pixel size is the same for all lines.

## Revendications

1. Détecteur (1) de lignes TDI, comprenant n lignes TDI (Zl-Zn), chaque ligne TDI (Z) présentant m pixels, et comprenant au moins une électronique de lecture (11-14),
**caractérisé en ce que**
le détecteur (1) de lignes TDI est divisé en x sous-modules (S1-S4), le nombre (Z) de lignes d'un sous-module (S1-S4) étant n/x, une électronique de lecture (11-14) propre étant associée à la dernière ligne de chaque sous-module (S1-S4), **en ce que** la longueur (L1) de l'électronique de lecture (11-14) correspond à un multiple entier de la longueur (L2) d'un pixel, x > 2, **en ce que** les sous-modules (S1-S4) ou groupes de sous-modules (S1-S4) sont décalés latéralement et en alternance d'un demi-pixel (P), **en ce que** les pixels (P) sont rectangulaires et **en ce que** la largeur des pixels (P) est le double de leur longueur.

2. Détecteur de lignes TDI selon la revendication 1, **caractérisé en ce que** 10 < x < 100.

3. Détecteur de lignes TDI selon les revendications 1 ou 2, caractérisé en ce que'au moins certains des sous-modules (S1-S4) présentent des filtres pour différentes plages de fréquences.

4. Détecteur de lignes TDI selon l'une des revendications précédentes, **caractérisé en ce que** les pixels ont la même taille dans toutes les lignes.
